# EUROPEAN PATENT APPLICATION

(11) **EP 2 784 382 A2**
(43) Date of publication of application: **01.10.2014**
(21) Application number: 13184051.4
(22) Date of filing: 12.09.2013
(51) Int. Cl.: F21V 23/04, F21K 99/00, H05B 33/08, F21V 25/04, G01J 1/04

(54) **Solid state lighting device**

(30) Priority: 25.03.2013 JP 2013063047
(71) Applicant: Toshiba Lighting & Technology Corporation, Yokosuka-shi, Kanagawa 237-8510 (JP)
(72) Inventor: Ishikawa, Masato, Kanagawa, 237-8510 (JP)
(74) Representative: Bokinge, Ole

(57) **Abstract**

According to one embodiment, a solid state lighting device includes an irradiating section (10), a scattering section (20), a wavelength conversion layer (40), a supporting plate (50), a returned light guiding section (90), a light receiving section (94), and a control circuit (80). The irradiating section (10) emits laser light (70). The scattering section (20) has a plane provided to cross an optical axis of the laser light (70) and includes a light scattering material that reflects the laser light (70) and emits the laser light (70) as scattered light (72). The wavelength conversion layer (40) absorbs the scattered light (72) made incident thereon and emits wavelength-converted light (73) having a wavelength longer than the wavelength of the scattered light (72). The supporting plate (50) has a light incident surface on which the wavelength conversion layer (40) is provided and a light emission surface. The scattered light (72) and the wavelength-converted light (73) change to returned light (92) and propagate through the inside of the supporting plate (50). The returned light (92) is introduced into the returned light guiding section (90). The light receiving section (94) detects the returned light (92). When a detected light amount of the returned light (92) is outside a predetermined range, the control circuit (80) outputs an emission stop signal for the laser light (70) to the irradiating section (10).

## Description

### FIELD

Embodiments described herein relate generally to a solid-state lighting device.

### BACKGROUND

A white solid state lighting (SSL) device includes a semiconductor light-emitting element such as an LED (Light Emitting Diode) or an LD (Laser Diode) and a wavelength conversion layer.

The solid state lighting device is strongly requested to have high brightness and high power. Therefore, emitted light of the semiconductor light-emitting element and wavelength-converted light by the wavelength conversion layer are requested to have higher power.

Therefore, if light is not normally emitted from the semiconductor light-emitting element and the wavelength conversion layer, for safety, the solid state lighting device desirably has a self-diagnosis function capable of detecting an abnormality.

An abnormality of illumination light can be detected if returned light generated in the solid state lighting device is used. However, abnormality detection sensitivity is insufficient unless a position for detecting the returned light is properly selected.

### BRIEF DESCRIPTION OF THE DRAWINGS

FIG. 1 is a configuration diagram of a solid state lighting device according to a first embodiment;
FIG. 2 is a configuration diagram of a solid state lighting device according to a comparative example;
FIG. 3A is a schematic plan view of a solid state lighting device according to a second embodiment;
FIG. 3B is a schematic sectional view taken along line A-A in FIG. 3A;
FIG. 4 is a configuration diagram of a solid state lighting device according to a third embodiment;
FIG. 5 is a configuration diagram of a solid state lighting device according to a fourth embodiment;
FIG. 6 is a configuration diagram of a solid state lighting device according to a fifth embodiment;
FIG. 7 is a configuration diagram of a solid state lighting device according to a sixth embodiment; and
FIG. 8 is a timing chart for explaining a self-diagnosis system.

### DETAILED DESCRIPTION

In general, according to one embodiment, there is provided a solid state lighting device including an irradiating section, a scattering section, a wavelength conversion layer, a supporting plate, a returned light guiding section, a light receiving section, and a control circuit. The irradiating section emits laser light. The scattering section has a principal plane provided to cross an optical axis of the laser light and includes a light scattering material that reflects the laser light made incident thereon and emits the laser light as scattered light. The wavelength conversion layer absorbs the scattered light made incident through a first surface and emits wavelength-converted light having a wavelength longer than the wavelength of the scattered light from a second surface on a side opposite to the first surface. The supporting plate has a light incident surface on which the wavelength conversion layer is provided and a light emission surface on a side opposite to the light incident surface. A part of the scattered light and a part of the wavelength-converted light change to returned light and propagate through the inside of the supporting plate. The returned light is led into one end of the returned light guiding section. The light receiving section detects the returned light emitted from a second end on a side opposite to the one end. When a detected light amount of the returned light is outside a predetermined range, the control circuit outputs an emission stop signal for the laser light to the irradiating section.

Embodiments are explained below with reference to the drawings.

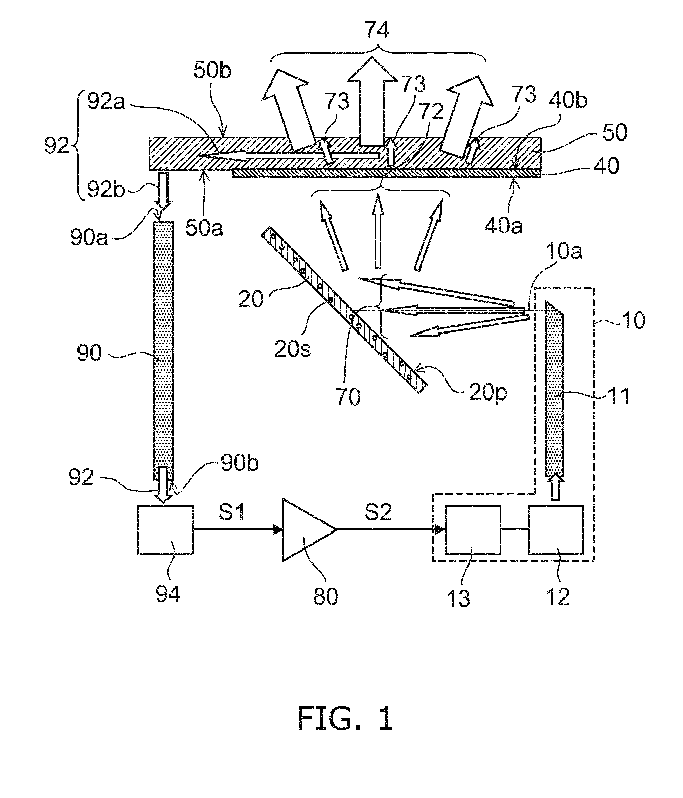

FIG. 1 is a configuration diagram of a solid state lighting device according to a first embodiment.

The solid state lighting device includes an irradiating section 10, a scattering section 20, a wavelength conversion layer 40, a supporting plate 50, a returned light guiding section 90, a light receiving section 94, and a control circuit 80.

The irradiating section 10 includes a light source 12 such as a semiconductor laser element and a driving circuit 13 for the light source 12. The irradiating section 10 may further includes a light guiding section 11 configured to transmit laser light 70 emitted from the light source 12. When the light guiding section 11 is an optical fiber, laser light led into one end of the optical fiber can be guided and emitted to the scattering section 20 from the other end. The wavelength of the laser light 70 can be a wavelength of, for example, 380 to 490 nm.

The scattering section 20 has a principal plane 20p provided to cross an optical axis 10a of the laser light 70. The scattering section 20 includes a light scattering material 20s that reflects the laser light 70 made incident thereon and emits the laser light 70 as scattered light 72. The light scattering material 20s can include particulates (particle diameter: 1 to 20 µm, etc.) of Al₂O₃, Ca₂P₂O₇, BaSO₄, or the like. The scattering section 20 may be a scattering section in which the particulates are distributed on a ceramic plate.

The wavelength conversion layer 40 absorbs the scattered light 72 made incident through a first surface 40a and emits wavelength-converted light 73 having a wavelength longer than the wavelength of the laser light 70 from a second surface 40b on a side opposite to the first surface 40a. The wavelength conversion layer 40 can be phosphor particles formed of YAG (Yttrium-Aluminum-Garnet) or the like. The phosphor particles absorb the scattered light 72 having a wavelength of 380 to 490 nm and emit wavelength-converted lights of yellow, green, red, and the like.

The scattered light 72 transmitted through the wavelength conversion layer 40 while being reflected and scattered without being absorbed by the wavelength conversion layer 40 and the wavelength-converted light 73 are emitted from the wavelength conversion layer 40. Then, mixed light 74 is generated from the scattered light 72 and the wavelength-converted light 73. When the wavelength of the scattered light 72 is 380 to 490 nm and the wavelength-converted light 73 is yellow light, the mixed light 74 can be white light or the like.

The supporting plate 50 has a light incident surface 50a on which the wavelength conversion layer 40 is provided and a light emission surface 50b on a side opposite to the light incident surface 50a. A part of the scattered light 72 and a part of the wavelength-converted light 73 propagate through the inside of the supporting plate 50 and then change to returned light 92a and are emitted to the outside.

Returned light 92b is emitted and introduced into one end 90a of the returned light guiding section 90. When the returned light guiding section 90 is an optical fiber, returned light 92 guided through the optical fiber is emitted from the other end.

The light receiving section 94 detects the returned light 92 emitted from the other end 90b of the optical fiber. The light receiving section 94 is a silicon photodiode or the like.

In the first embodiment, the optical axis 10a of the laser light 70 obliquely crosses the principal plane 20p of the scattering section 20. That is, the scattering section 20 has the principal plane 20p provided to obliquely (which means not perpendicular) cross the optical axis 10a of the laser light 70. The laser light 70 made incident on the scattering section 20 from the principal plane 20p is reflected and scattered by the light scattering material 20s dispersed in the scattering section 20 and is emitted. Even if damage to the scattering section 20 or the wavelength conversion layer 40 occurs, it is possible to suppress the laser light 70 from directly irradiating a lighting target. Therefore, it is possible to secure safety for human eyes and the like.

When detecting with an electric signal S1 output from the light receiving section 94 that a light amount of the returned light 92 is outside a predetermined range, the control circuit 80 outputs an emission stop signal S2 for the laser light 70 to the driving circuit 13 configuring the irradiating section 10.

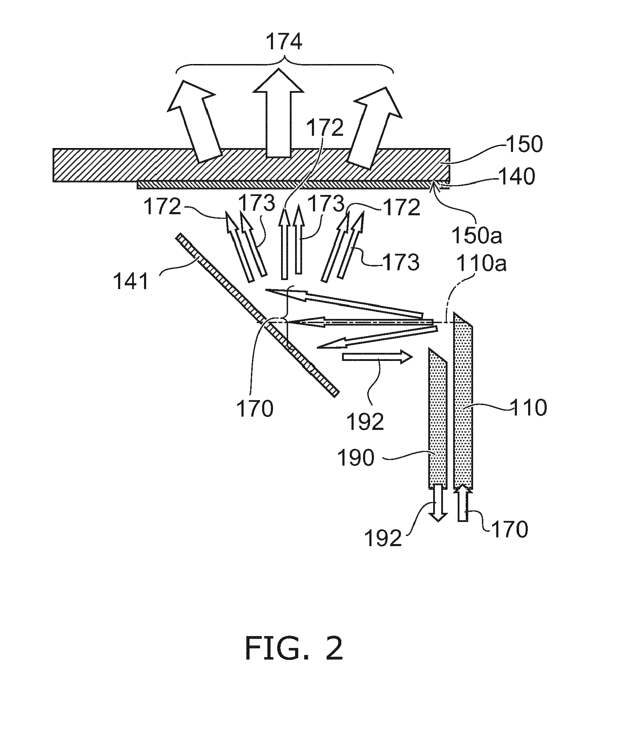

FIG. 2 is a configuration diagram of a solid state lighting device according to a comparative example.

A light source, a driving circuit, a light receiving section, and a control circuit are not shown in the figure. A wavelength conversion layer 140 is provided on a light incident surface 150a of a supporting plate 150. A wavelength conversion layer 141 is provided to cross an optical axis 110a of laser light 170. Wavelength-converted light 173 and scattered light 172 are emitted to the supporting plate 150 from the wavelength conversion layer 141.

An optical fiber 190 configuring a returned light guiding section detects returned light 192 on an incident side to the wavelength conversion layer 141. However, the optical fiber 190 cannot detect returned light on an emission side of the wavelength conversion layer 140. Therefore, even if the wavelength conversion layers 140 and 141 and the supporting plate 150 are damaged, a fluctuation level of the returned light 192 is small. Abnormality detection sensitivity is not considered to be sufficient. Therefore, it is difficult to secure safety. On the other hand, in the first embodiment, the returned light 92 made incident on the light receiving section 94 directly monitors a part of illumination light irradiated on a target. Therefore, it is possible to keep the abnormality detection sensitivity high and further improve safety.

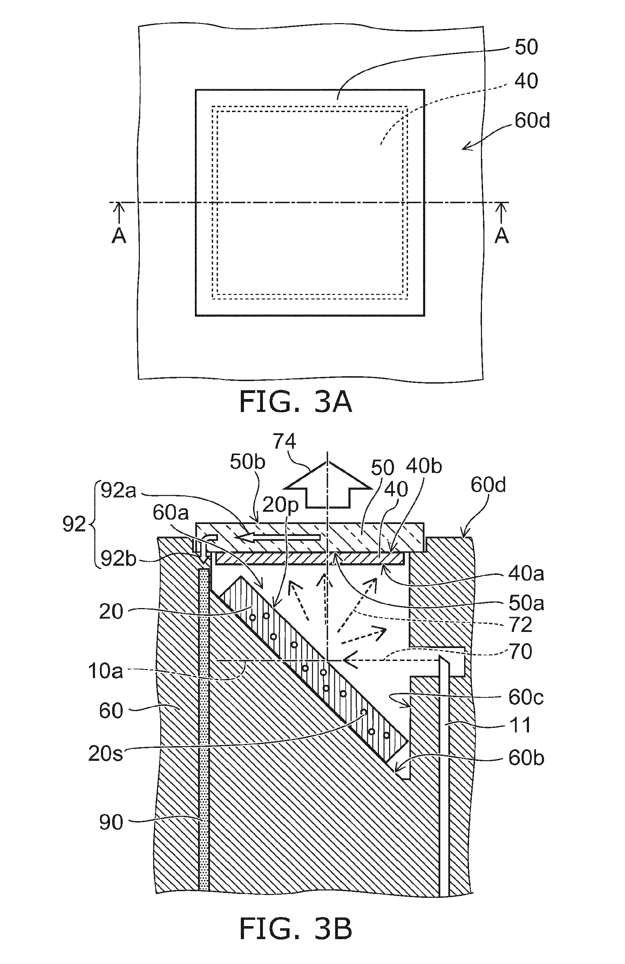

FIG. 3A is a schematic plan view of a solid state lighting device according to a second embodiment. FIG. 3B is a schematic sectional view taken along line A-A in FIG. 3A.

The solid state lighting device can further include a base section 60. A recess 60a receding from an upper surface 60d of the base section 60 is provided in the base section 60. The recess 60a has inner walls 60b and 60c. The scattering section 20 is provided on the inner wall 60b of the recess 60a. The irradiating section 10 is provided in a region opposed to the scattering section 20 on the inner wall 60c of the recess 60a.

In FIG. 3A, the wavelength conversion layer 40 is substantially square. The scattering section 20 is provided on the inner wall 60b of the recess 60a and is rectangular. The shape of the scattering section 20 in this embodiment is not limited to this and may be a polygon, a trapezoid, and the like. The recess 60a may be a remainder left after a cone or a pyramid is cut off from the upper surface 60d of the base section 60.

When the power of the laser light 70 increases, heat values in the wavelength conversion layer 40 and the scattering section 20 increase. If the base section 60 is made of metal such as Al, Cu, Ti, Si, Ag, Au, Ni, Mo, W, Fe, or Nb, thermal radiation is improved. Therefore, it is possible to improve light emission efficiency and reliability. When the laser light 70 is low power, the base section 60 does not have to be the metal and can be ceramic, heat-conductive resin, or the like.

The wavelength conversion layer 40 can be an applied layer applied and hardened on the light incident surface 50a of the supporting plate 50. The supporting plate 50 can be glass, transparent ceramic, or the like.

As shown in FIG. 3B, the supporting plate 50 is provided to form the recess 60a of the base section 60 as a closed space. When the light incident surface 50a of the supporting plate 50 and the upper surface 60d of the base section 60 are bonded, it is possible to absorb the laser light 70 and radiate heat generated in the wavelength conversion layer 40 to the base section 60. Therefore, it is possible to suppress deterioration in conversion efficiency of the wavelength conversion layer 40 due to a temperature rise. A cutout section may be provided on the upper surface 60d of the base section 60 and the supporting plate 50 may be interposed in the cutout section and bonded. The scattering section 20 may be omitted. The laser light 70 may be reflected on the inner wall 60b of the base section 60 and emitted to the supporting plate 50.

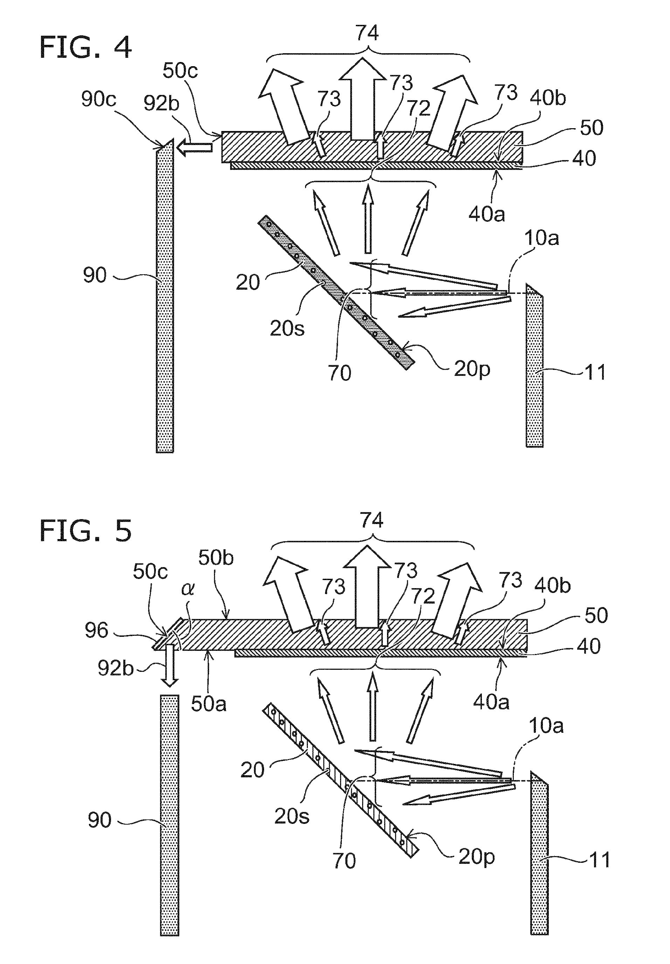

FIG. 4 is a configuration diagram of a solid state lighting device according to a third embodiment.

The supporting plate 50 further have a side surface 50c provided between the light incident surface 50a and the light emission surface 50b.

One end of the optical fiber configuring the returned light guiding section 90 has an oblique cut surface 90c.

The returned light 92b emitted from the side surface 50c of the supporting plate 50 is reflected on the oblique cut surface 90c and surely led into the optical fiber.

FIG. 5 is a configuration diagram of a solid state lighting device according to a fourth embodiment.

The side surface 50c of the supporting plate 50 is inclined at an acute angle α with respect to the light incident surface 50a of the supporting plate 50. In the returned light 92a propagated through the supporting plate 50, light having an incident angle on the inclined side surface 50c larger than a critical angle is totally reflected and travels to one end of the optical fiber.

A reflecting layer 96 can be further provided on the inclined side surface 50c of the supporting plate 50. If the reflecting layer 96 is made of Ag or Al having high reflectance to blue light, most of the light made incident on the side surface 50c can be reflected. The returned light 92 can be detected at higher sensitivity.

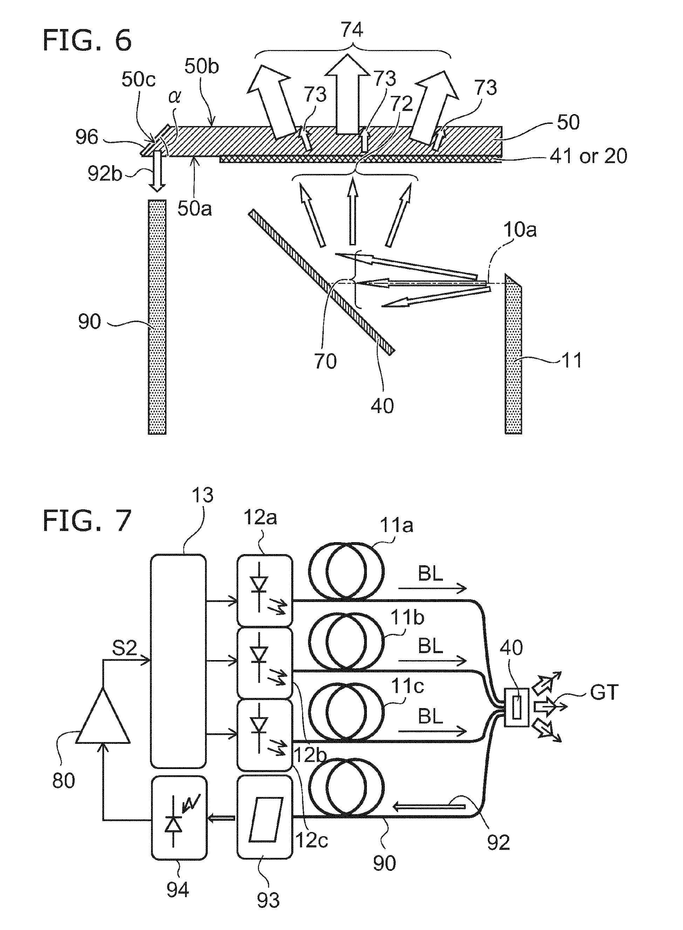

FIG. 6 is a configuration diagram of a solid state lighting device according to a fifth embodiment.

The laser light 70 may be irradiated on the principal plane of the first wavelength conversion layer 40 instead of the scattering section. First wavelength-converted light having a wavelength larger than the wavelength of the laser light 70 and the scattered light 72 changed from the laser light 70 in the first wavelength conversion layer 40 are emitted to the supporting plate 50. The solid state lighting device may further include the scattering section 20 including a scattering material or a second wavelength conversion layer 41 on the side of the light incident surface 50a of the supporting plate 50. When the scattering section 20 is provided, the first wavelength-converted light and the scattered light 72 are further scattered and emitted from the light emission surface 50b.

When the second wavelength conversion layer 41 is provided, the scattered light 72 from the first wavelength conversion layer 40 is absorbed. Second wavelength-converted light 73 having a wavelength larger than the wavelength of the scattered light 72 is emitted from the light emission surface 50b of the supporting plate 50. At the same time, the first wavelength-converted light and the scattered light 72 are also emitted from the light emission surface 50b.

FIG. 7 is a configuration diagram of a solid state lighting device according to a sixth embodiment.

The solid state lighting device according to the sixth embodiment includes the light source 12 including a plurality of semiconductor laser elements. When a solid state lighting device includes a plurality of semiconductor laser elements and a plurality of optical fibers, even if an abnormality occurs in any one of optical paths, an amount of change of the returned light 92 is small compared with an entire light amount of the returned light 92. Therefore, abnormality detection sensitivity is insufficient. In the case of a solid state lighting device including a plurality of semiconductor laser elements, it is necessary to specify an abnormality occurrence place. The solid state lighting device according to the sixth embodiment is a solid state lighting device including a self-diagnosis system that specifies a semiconductor laser in which an abnormality occurs.

In FIG. 7, the solid state lighting device includes three semiconductor laser elements 12a, 12b, and 12c and three optical fibers 11a, 11b, and 11c that respectively guide blue laser lights BL. The respective blue laser lights BL from the semiconductor laser elements are respectively made incident on one end faces of the optical fibers 11, which are opposed to the semiconductor laser elements, and guided and then respectively emitted from the other end faces of the optical fibers 11 and irradiate the scattering section 20.

The returned light 92 is guided through the returned light guiding section 90 (an optical fiber) and made incident on a blue cut filter 93. In the returned light 92, a component left after an emission spectrum near the blue light BL is cut is made incident on the light receiving section 94.

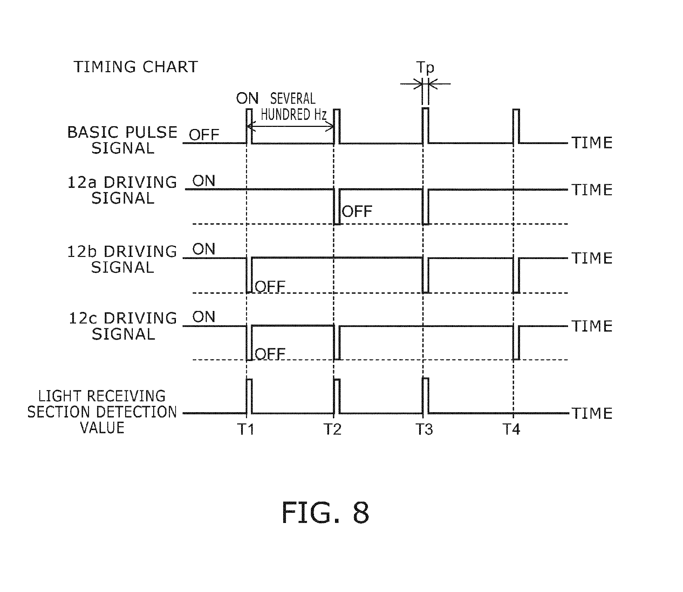

FIG. 8 is a timing chart for explaining the self-diagnosis system.

The driving circuit 13 generates, at a repetition frequency f, a basic pulse signal having pulse width Tp. The repetition frequency f can be, for example, several hundred hertz, which is hard to be sensed by human eyes. Only the first semiconductor laser element 12a is on between time T1 and time (T1+Tp). If the light receiving section 94 detects that a light amount of the first semiconductor laser element 12a is within a predetermined range, the self-diagnosis system determines that the operation of the solid state lighting device is normal.

On the other hand, if the light receiving section 94 detects that the light amount of the first semiconductor laser element 12a is outside the predetermined range as shown between time T4 and time (T4+Tp), the self-diagnosis system determines that an abnormality such as breakage of the optical fiber 11a, breakage of the wavelength conversion layer 40, or deterioration of the semiconductor laser element 12a occurs.

Only the second semiconductor laser element 12b is on between time T2 and time (T2+Tp). Only the third semiconductor laser element 12c is on between time T3 and time (T3+Tp). After one cycle of the generation of the basic pulse signal ends, this process is repeated. As a result, it is possible to self-diagnose whether the operation of the solid state lighting device is normal.

That is, when a plurality of independent optical paths including the semiconductor laser elements 12, the optical fibers 11, and the wavelength conversion layer 40 are provided, an optical path in which an abnormality occurs is specified and the emission stop signal S2 for the laser light 70 is output to the irradiating section 10. Therefore, it is possible to improve safety of the solid state lighting device by stopping the driving of the semiconductor laser element of the optical path in which the abnormality occurs.

According to the first to sixth embodiments, the optical axis 10a of the laser light 70 obliquely crosses the principal plane 20p of the scattering section 20. Therefore, even if damages to the scattering section 20 and the wavelength conversion layer 40 occurs, it is possible to suppress the laser light 70 from directly irradiating a lighting target. Further, the returned light 92 made incident on the light receiving section 94 directly monitors a part of illumination light that irradiates the target. Therefore, it is possible to keep abnormality detection sensitivity high. As a result, it is possible to obtain the solid state lighting device with improved safety.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A solid state lighting device comprising:
an irradiating section (10) configured to emit laser light (70);
a scattering section (20) having a principal plane provided to cross an optical axis of the laser light (70) and including a light scattering material that reflects the laser light (70) made incident thereon and emits the laser light (70) as scattered light (72);
a wavelength conversion layer (40) configured to absorb the scattered light (72) made incident through a first surface and emit wavelength-converted light (73) having a wavelength longer than a wavelength of the scattered light (72) from a second surface on a side opposite to the first surface;
a supporting plate (50) having a light incident surface on which the wavelength conversion layer (40) is provided and a light emission surface on a side opposite to the light incident surface, a part of the scattered light (72) and a part of the wavelength-converted light (73) changing to returned light (92) and propagating through an inside of the supporting plate (50);
a returned light guiding section (90) into one end of which the returned light (92) is introduced;
a light receiving section (94) configured to detect the returned light (92) emitted from a second end of the returned light guiding section (90) on a side opposite to the one end; and
a control circuit (80) configured to output an emission stop signal for the laser light (70) to the irradiating section (10) when a detected light amount of the returned light (92) is outside a predetermined range.

2. A solid state lighting device comprising:
an irradiating section (10) configured to emit laser light (70);
a first wavelength conversion layer (40) having a principal plane provided to cross an optical axis of the laser light (70) and configured to absorb the laser light (70) made incident thereon and emit a first wavelength-converted light (73) having a wavelength longer than a wavelength of the laser light (70) and scattered light (72) changed from the laser light (70) to above the principal plane;
a supporting plate (50) having a light incident surface on which the first wavelength-converted light (73) and the scattered light (72) are made incident and a light emission surface on a side opposite to the light incident surface, a part of the scattered light (72) and a part of the first wavelength-converted light (73) changing to returned light (92) and propagating through an inside of the supporting plate (50);
a returned light guiding section (90) into one end of which the returned light (92) is introduced;
a light receiving section (94) configured to detect the returned light (92) emitted from a second end of the returned light guiding section (90) on a side opposite to the one end; and
a control circuit (80) configured to output an emission stop signal for the laser light (70) to the irradiating section (10) when a detected light amount of the returned light (92) is outside a predetermined range.

3. The device according to claim 2, further comprising:
a second wavelength conversion layer (41) provided on the light incident surface of the supporting plate (50) and configured to absorb the scattered light (72) and make second wavelength-converted light (73) having a wavelength longer than a wavelength of the scattered light (72) incident on the light incident surface and further scatter the scattered light (72) and make the scattered light (72) incident on the light incident surface.

4. The device according to claim 2, further comprising:
a scattering section (20) provided on the light incident surface of the supporting plate (50) and including a light scattering material that further scatters the first wavelength-converted light (73) and the scattered light (72).

5. A solid state lighting device comprising:
an irradiating section (10) configured to emit laser light (70);
a reflecting layer (96) provided to cross an optical axis of the laser light (70) and configured to reflect the laser light (70) upward;
a wavelength conversion layer (40) configured to absorb the reflected light by the reflecting layer (96) and emit wavelength-converted light (73) having a wavelength longer than a wavelength of the laser light (70) and scattered light (72) changed from the laser light (70);
a supporting plate (50) having a light incident surface on which the wavelength conversion layer (40) is provided and a light emission surface on a side opposite to the light incident surface, a part of the scattered light (72) and a part of the wavelength-converted light (73) changing to returned light (92) and propagating through an inside of the supporting plate (50);
a returned light guiding section (90) into one end of which the returned light (92) is introduced;
a light receiving section (94) configured to detect the returned light (92) emitted from a second end of the returned light guiding section (90) on a side opposite to the one end; and
a control circuit (80) configured to output an emission stop signal for the laser light (70) to the irradiating section (10) when a detected light amount of the returned light (92) is outside a predetermined range.

6. The device according to one of claims 1 to 5, wherein the returned light guiding section (90) includes an optical fiber.

7. The device according to claim 6, wherein the supporting plate (50) further has a side surface provided between the light incident surface and the light emission surface,
the one end of the optical fiber has an oblique cut surface, and
the returned light (92) emitted from the side surface is reflected on the oblique cut surface and introduced into the optical fiber.

8. The device according to claim 6, wherein the side surface of the supporting plate (50) is inclined at an acute angle with respect to the light incident surface of the supporting plate (50).

9. The device according to claim 8, further comprising:
a reflecting layer (96) provided on the side surface of the supporting plate (50).
